(19) Europäisches Patentamt
European Patent Office
Office européen des brevets

(11) **EP 2 259 354 A2**

(12) **EUROPEAN PATENT APPLICATION**

(43) Date of publication:
**08.12.2010 Bulletin 2010/49**

(51) Int Cl.:
**H01L 51/05** *(2006.01)* **H01L 51/00** *(2006.01)*

(21) Application number: **10178379.3**

(22) Date of filing: **23.03.2005**

(84) Designated Contracting States:
**AT BE BG CH CY CZ DE DK EE ES FI FR GB GR HU IE IS IT LI LT LU MC NL PL PT RO SE SI SK TR**

(62) Document number(s) of the earlier application(s) in accordance with Art. 76 EPC:
**05709076.3 / 1 922 773**

(71) Applicant: **Türkiye Sise Ve Cam Fabrikalari A.S.**
**34130 Istanbul (TR)**

(72) Inventors:
• **Icli, Siddik**
  **35100, Izmir (TR)**
• **Sariciftci, Serdar**
  **4040, Linz (AT)**
• **Erten, Sule**
  **35100, Izmir (TR)**

• **Birendra, Singh**
  **4040, Linz (AT)**
• **Yildirim, Teoman**
  **34130, Istanbul (TR)**
• **Kuban, Baha**
  **34130, Istanbul (TR)**

(74) Representative: **Schurack, Eduard F.**
**Hofstetter, Schurack & Skora**
**Patentanwälte**
**Balanstrasse 57**
**81541 München (DE)**

Remarks:
This application was filed on 22-09-2010 as a divisional application to the application mentioned under INID code 62.

(54) **Perylene imide/diimide based organic field effect transistors-OFETs and a method of producing the same**

(57) This invention relates to a method of solution-processed construction of ambipolar, air stable organic field-effect transistors (OFETs) based on perylene diimide/imide derivatives that absorb in visible region and the product obtained therefrom. The synthesis, design and application of ambipolar organic field-effect transistors (OFETs) based on N,N'-bis(dehydroabietyl)-3,4,9,10-perylene diimide (PDI) derivative has shown electron mobility, $\mu_e \approx 7 \times 10^{-5}$ cm$^2$.V$^{-1}$.s$^{-1}$ and hole mobility, $\mu_h \approx 8 \times 10^{-5}$ cm$^2$.V$^{-1}$.s$^{-1}$. Less soluble, air stable, unipolar n-channel OFET based on N-(cyclohexyl)perylene-3,4,9,10-tetracarboxylic-3,4-anhydride-9,10-imide showed an electron mobility of $\mu_e \approx 10^{-5}$ cm$^2$.V$^{-1}$.s$^{-1}$.

Fig. 1

EP 2 259 354 A2

## Description

In organic electronics, much progress has been made in recent years in the development of FET based on organic semi conductors, OFETs. Related information can be found in Applied Physics Letters by Th. B. Singh et al. Appl. Phys. Lett. 85, 5409 (2004); Nanoelectronics and Information Technology: Advanced Elecronics Materials and Novel Devices, edited by R.Waser (2003) and C. D. Dimitrakopoulos and D. J. Mascaro, IBM J. Res. Dev., 45, 11 (2001); G. Horowitz, Adv. Funct. Mater., 13, 53 (2003).

There has been a growing interest in researches on OFETs with high mobility ($\mu$) utilizing the large field of material chemistry. (See. V. Podzorov, S. E. Sysoev, E. Loginova, V. M. Pudalov and M. E. Gershenson, Appl. Phys. Lett., 83, 3504 (2003)).

OFET-Organic field-effect transistors among the general organic electronic devices are of great interest for switching devices, flexible displays, smart cards and in large area sensors. The advantage of these devices are the combination of solution processable and potentially lower cost fabrications such as printing over the existing device technology.

OFET applications using low-cost production and large area coverage such as radio frequency IDs, smart tags, textile integrated electronics, etc.. are known. For reference, see J. A. Rogers, Z. bao, K. Baldwin, A. Dodabalapur, B. Crone, V. R. Raju, V. Kuck, H. Katz, K. Amundson, J. Ewing and P. Drzaic, Proc. Natl. Acad. Sci. USA, 98, 4835 (2001).

Solution-processed large area printable OFETs have a great potential in future applications.

In the present invention, ambipolar, solution processed n-channel organic field effect transistors (OFETs) having high mobilities based on perylene diimide, PDI, absorbing in visible region (< 530 nm) derivatives are disclosed.

The synthesis, design and application of n-channel organic field effect transistors (OFETs) based on N,N'-bis (dehydroabietyl)-3,4,9,10-perylene diimide (PDI) derivative has shown electron mobility, $\mu_e \approx 7 \times 10^{-5}$ cm$^2$.V$^{-1}$ .s$^{-1}$ and hole $\mu_h \approx 8 \times 10^{-5}$ cm$^2$.V$^{-1}$.s$^{-1}$. Less soluble, air stable, n-channel based N-(cyclohexyl)perylene-3,4,9,10-tetracarboxylic-3,4-anhydride-9,10-imide showed a mobility of $\mu_e \approx 10^{-5}$ cm$^2$.V$^{-1}$.s$^{-1}$.

PhotOFETs, functioning under solar irradiations, can also be constructed with perylene imides/diimides.

H. E. Katz reports the NDI based OFETs, constructed by vapor phase deposition. For reference see:

a) H. E. Katz, J. Johnson, A. J. Lovinger and W. Li, J. Am. Chem. Soc, 122, 7787 (2000); and
b) H. E. Katz, W. Li, A. J. Lovinger, US Patent US 6387727 B1 (May 14, 2002), (Agere Systems Guardian Corp., USA).

Some aspects of the invention relate to:

1. A method of constructing solution processed, ambipolar, air stable organic field effect transistors (OFETs) based on perylene dimide/imide derivatives that absorb in visible region comprising the steps of: a) cleaning and patterning of electrically conductive indium tin oxide (ITO) coated glass substrate; b) spin coating of a transparent film of PVA (poly-vinyl alcohol) dielectric layer having average molecular weight of 127.000 (Mowiol® 40-88) on top of ITO; c) spin coating of a transparent film of divinyltetramethyldisiloxane-bis(benzocyclobutene) BCB as a dielectric layer on top of ITO having a thickness in the range of 1 to 3 $\mu$m.

2. A method of constructing a organic field effect transistors (OFETs) of point 1, wherein in step (c), the thickness of the dielectric layer is in the range of 1.5 to 2.5 $\mu$m.

3. A method of constructing a organic field effect transistors (OFETs) of point 1, wherein instead of step (c), the PVA/ BCB covered ITO/glass subtrate is spin coated with a semiconductor layer of dehydroabietyl perylene diimide having a roughness of < 5 nm.

4. A method of constructing a organic field effect transistors (OFETs) of point 1, wherein instead of step (c), PVA/BCB covered ITO/glass subtrate is spin coated with a semiconductor layer of cyclohexyl perylene anyhdride-imide having a roughness of < 5 nm.

5. A method of constructing a organic field effect transistors (OFETs) of point 1, wherein instead of step (c), the glass subtrate is spin coated with a semiconductor layer of poly-crystalline n-butyl naphthalene dimide.

6. A method of constructing a organic field effect transistors (OFETs) of points 1 to 5, wherein the method also comprises a step in which LiF/Al layer having a thickness in source and drain electrodes of 0.6 nm/60 nm, respectively and the channel length in 35 $\mu$m and channel width of 1.4 mm.

7. An n-channel organic field effect transistor (OFET) with a solution spin coated aromatic imide/diimide semiconductor layer that absorb in visible region produced by the methods of points 1 to 6.

The invention is described herebelow and in drawings attached hereto wherein:

Figure 1 is a scheme of the staggered mode n-channel OFET device structure.

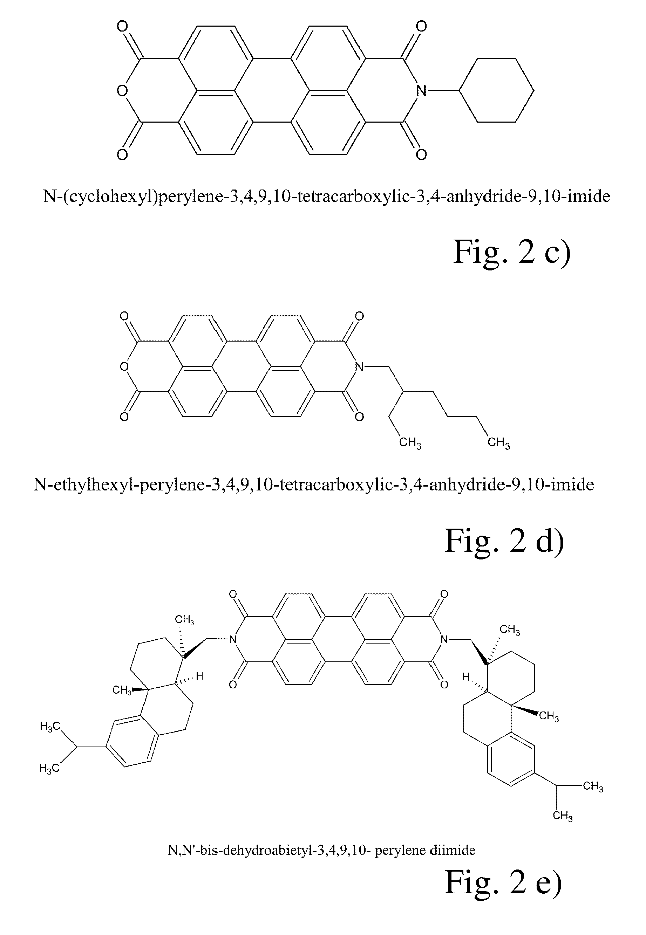

Figure 2 shows the molecular structures employed in OFETs: a) BCB dielectric polymer, b) PVA (MOWIOL) dielectric polymer, c) N,N'-bis-(dehydroabietyl)-3,4,9,10-perylenebis(dicarboximide) semiconductor, d) N-(cyclohexyl)perylene-3,4,9,10-tetracarboxylic-3,4-anhydride-9,10-imide semiconductor, e) N,N'-bis-(butyl)-1,4,5,8-naphthalenebis(dicarboximide) semiconductor, f) Naphthalene dibenzimidazole semiconductor.

Figure 3 is the transistor output $I_{ds}$ vs. $V_{ds}$ and transfer $I_{ds}$ vs. $V_{gs}$ characteristics of OFET with N,N'-bis-(butyl)-1,4,5,8-naphthalenebis(dicarboximide) as an active semiconducting layer.

Figure 4 shows the AFM images of N,N'-bis-(butyl)-1,4,5,8-naphthalenebis(dicarboximide) thin film spin coated on top of a PVA film.

Figure 5 shows output $I_{ds}$ vs. $V_{ds}$ characteristics OFET curves of ambipolar OFET with N,N'-bis-(dehydroabietyl)-3,4,9,10-perylenebis(dicarboximide) as an active semiconducting layer.

Figure 6 shows transfer $I_{ds}$ vs. $V_{gs}$ characteristics of N,N'-bis-(dehydroabietyl)-3,4,9,10-perylenebis(dicarboximide) FET showing electron enhancement current at positive gate voltage and hole enhancement current at negative gate voltage.

Figure 7 shows AFM image of ambipolar N,N'-bis-(dehydroabietyl)-3,4,9,10-perylenebis(dicarboximide) on PVA coated film.

Solution processed n-channel organic field effect transistors (OFETs) based on N,N'-bis(butyl)-1,4,5,8-naphthalene diimide (NDI) derivative, constructed as a reference to PDI-OFET.; Strong electron accepting ability and good solubility have been disclosed. NDI based OFETs showed mobilities up to 0.05 cm$^2$ V$^{-1}$ s$^{-1}$ and operated both in inert conditions and air. Mobility of n-butyl NDI is higher than the reported thin film alkyl derivative of NDI OFET 0.03 cm$^2$ V$^{-1}$ s$^{-1}$. Naphthalene diimides absorb in UV range < 380 nm. The crystalline structure of NDI in OFET device is proven by atomic force microscopy (AFM) pictures.

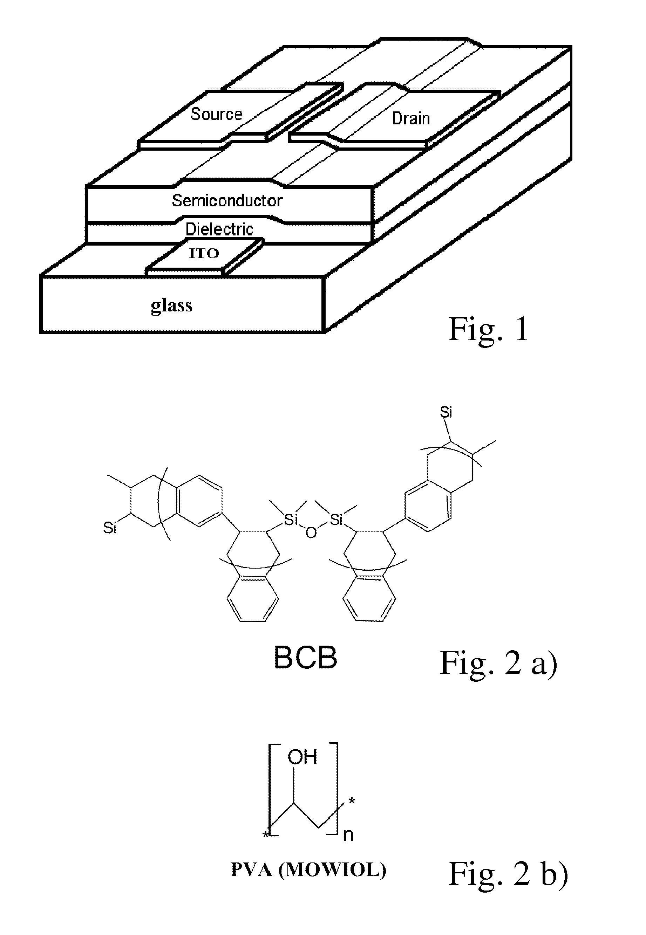

A schematic view of the device is shown in Figure 1. The manufacturing process of the device starts with etching the electrically conductive indium tin oxide (ITO) on the glass substrate. After patterning the ITO and cleaning in the ultrasonic bath, PVA (poly-vinyl alcohol) dielectric layer with average molecular weight of 127.000 (Mowiol® 40-88 from Sigma-Aldrich®) is spin-coated from water solution with a 10 %-wt. ratio. A highly viscous PVA solution gives a transparent film by spin coating at 1500 rpm which results in 2 $\mu$m thick film forming the dielectric layer. Same experiment was conducted with divinyltetramethyldisiloxane-bis(benzocyclobutene) BCB as dielectric layer. BCB was used as received from Dow Chemicals and curing was done according to the standard procedure which is described in Lay-Lay Chua, Peter K. H. Ho, Henning Sirringhaus and R.H. Friend, Appl. Phys. Lett., 84, 3400 (2004).

The top source and drain electrode, made from LiF/Al (0.6/60 nm), was evaporated under vacuum (2 x 10$^{-6}$ mbar) through a shadow mask. The channel length, L of the device is 35 $\mu$m with channel width, W = 1.4 mm which resulted in W/L ratio of $\approx$ 40. From the measurement of dielectric thickness (d = 2 $\mu$m; $\varepsilon_{BCB}$ = 2.6) a dielectric capacitance $C_{BCB}$ =1.2 nF/cm$^2$ was estimated. All device transport and electrical characterisation was carried out both in air and under argon environment. Keithley® 236 and Keithley® 2400 Source-Measurements Units instruments were used for the steady state current-voltage measurements. Surface morphology and thickness of the dielectric was determined with a Digital Instrument@ 3100 atomic force microscope (AFM) and a Dektak® surface profilometer.

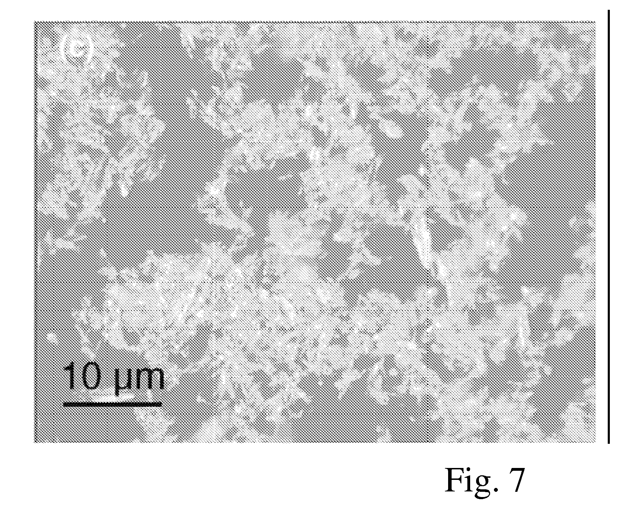

As shown in Figure 7, the semiconductor layer of dehydroabietyl perylene diimide has a very smooth surface with roughness of < 5 nm, a spin coated layer at thickness of 150 nm. Perylene diimides and monoimides absorb in visible region < 530 nm. In a recent study, it was proved that the first few mono layers next to the dielectric layer dominate the charge transport. See. F. Dinelli, M. Murgia, P. Levy , M. Cavallini, F. Biscarini, D. M. de Leeuw, Phys. Rev. Lett., 92, 116802 (2004).

LiF/Al has been selected as drain and source electrode as it is expected to form ohmic contact on aromatic imides (See a) V. D. Mihailetchi, J. K. J. van Duren, P. W. M. Blom, J. C. Hummelen, R. A. J. Janssen, J. M. Kroon, M. T. Rispens, W. J. H. Verhees and M. M. Wienk, Adv. Func. Mater. 13, 43 (2003). b) G. J. Matt, N. S. Sariciftci and T. Fromherz, Appl. Phys. Lett. 84, 1570 (2004)).

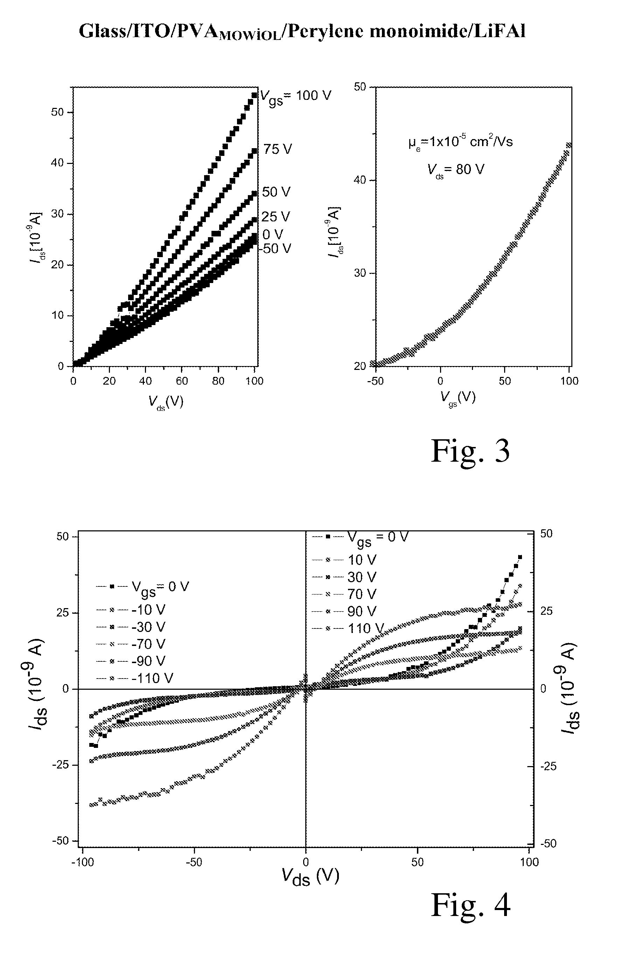

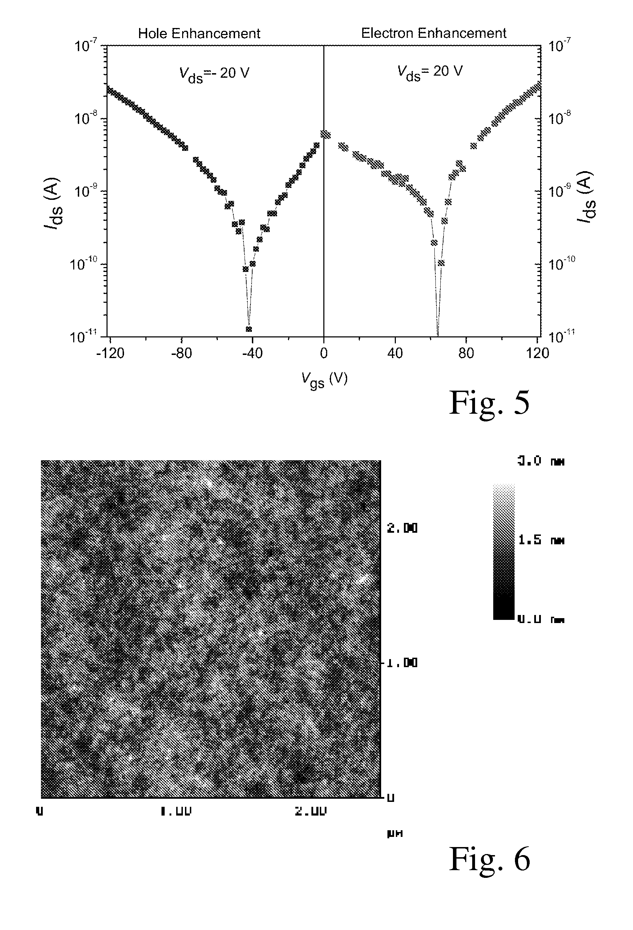

Figures 3 and 5 show the typical transistor and transfer characteristics of a device with a well saturated curve occurring pinch off at drain source voltage $V_{ds(sat)}$ 3 $V_{gs}$ (gate Voltage). For the same device (Figures 3 and 5) the transfer characteristics at different $V_{ds}$ have been measured.

As seen in figures 3 and 5, according to the equation (1): (S. M. Sze, Physics of Semiconductor Devices (Wiley, New York, 1981)

$$I_{ds} = \frac{\mu W C_{BCB}}{2L} (V_g - V_t)^2 \qquad (1)$$

N,N'-bis(dehydroabietyl)-3,4,9,10-perylenediimide (PDI) derivative has shown electron mobility of $\mu = 7 \times 10^{-5}$ $cm^2.V^{-1}.s^{-1}$ and hole mobility $8 \times 10^{-5}$ $cm^2.V^{-1}.s^{-1}$. Low solubility, air stable, n-channel based N-(cyclohexyl)perylene-3,4,9,10-tetracarboxylic-3,4-anhydride-9,10-imide showed electron mobility $\mu_\varepsilon = 10^{-5}$ $cm^2.V^{-1}.s^{-1}$. N,N'-bis(butyl)-1,4,5,8-naphthalenediimide, NDI, derivative, constructed as a reference to PDI-OFET; strong electron accepting ability and good solubility have been featured. NDI based OFETs showed electron mobilities $\mu$ up to 0.05 $cm^2.V^{-1}.s^{-1}$ and operated in both inert conditions and air. Mobility of n-butyl NDI is higher than the reported thin film NDI OFET 0.03 $cm^2.V^{-1}.s^{-1}$. (For reference see H. E. Katz, J. Johnson, A. J. Lovinger and W. Li, J. Am. Chem. Soc, 122, 7787 (2000))

**Claims**

1. A method of constructing a solution processed, ambipolar, air stable organic field effect transistor (OFET) comprising the steps of:

   a) patterning of electrically conductive indium tin oxide (ITO) on a glass substrate and cleaning of the patterned ITO;
   b) spin coating a transparent film of PVA (poly-vinyl alcohol) having an average molecular weight of 127.000 as a dielectric layer on top of the ITO or spin coating a transparent film of divinyltetramethyldisiloxane-bis(benzocyclobutene) BCB as the dielectric layer on top of the ITO, wherein the dielectric layer has a thickness in the range of 1 to 3 mm;
   c) spin coating N,N'-bis-(dehydroabietyl)-3,4,9,10-perylenebis(dicarboximide), N-(cyclohexyl)perylene-3,4,9,10-tetracarboxylic-3,4-anhydride-9,10-imide, or N,N'-bis-(butyl)-1,4,5,8-naphthalenebis(dicarboximide) as a semiconductor layer on the dielectric layer; and
   d) evaporating LiF/Al source and drain electrodes on top of the semiconductor layer under vacuum through a shadow mask.

2. The method of claim 1, wherein in step b) the dielectric layer is spin coated with a thickness in the range of 1.5 to 2.5 mm.

3. The method of claim 1, wherein the dielectric layer is spin coated with a semiconductor layer of N,N'-bis-(dehydroabietyl)-3,4,9,10-perylenebis(dicarboximide) or N-(cyclohexyl)perylene-3,4,9,10-tetracarboxylic-3,4-anhydride-9,10-imide, the dielectric layer having a roughness of < 5 nm.

4. The method of claims 1 to 3, wherein the LiF/Al source and drain electrodes have a thickness of 0.6 nm/60 nm, respectively, a channel length of 35 mm, and a channel width of 1.4 mm.

5. An n-channel organic field effect transistor (OFET) with:

   a) electrically conductive indium tin oxide (ITO) on a glass substrate;
   b) a spin coated dielectric layer of a transparent film of PVA (poly-vinyl alcohol) hav-ing an average molecular weight of 127.000 or a spin coated dielectric layer of a transparent film of divinyltetramethyldisiloxane-bis(benzocyclobutene) BCB;
   c) a spin coated aromatic imide/diimide semiconductor layer, wherein the aromatic imide/diimide is N,N'-bis-(dehydroabietyl)-3,4,9,10-perylenebis(dicarboximide), N-(cyclohexyl)perylene-3,4,9,10-tetracarboxylic-3,4-anhydride-9,10-imide, or N,N'-bis-(butyl)-1,4,5,8-naphthalenebis(dicarboximide); and
   d) LiF/Al source and drain electrodes evaporated on top of the semiconductor layer under vacuum through a shadow mask.

Fig. 1

BCB

Fig. 2 a)

PVA (MOWIOL)

Fig. 2 b)

N-(cyclohexyl)perylene-3,4,9,10-tetracarboxylic-3,4-anhydride-9,10-imide

Fig. 2 c)

N-ethylhexyl-perylene-3,4,9,10-tetracarboxylic-3,4-anhydride-9,10-imide

Fig. 2 d)

N,N'-bis-dehydroabietyl-3,4,9,10- perylene diimide

Fig. 2 e)

# Glass/ITO/PVA$_{MOWIOL}$/Perylene monoimide/LiFAl

Fig. 3

Fig. 4

Fig. 5

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6387727 B1

**Non-patent literature cited in the description**

- **Th. B. Singh et al.** *Appl. Phys. Lett.,* 2004, vol. 85, 5409
- Nanoelectronics and Information Technology: Advanced Elecronics Materials and Novel Devices. 2003
- **C. D. Dimitrakopoulos ; D. J. Mascaro.** *IBM J. Res. Dev.,* 2001, vol. 45, 11
- **G. Horowitz.** *Adv. Funct. Mater.,* 2003, vol. 13, 53
- **V. Podzorov ; S. E. Sysoev ; E. Loginova ; V. M. Pudalov ; M. E. Gershenson.** *Appl. Phys. Lett.,* 2003, vol. 83, 3504
- **J. A. Rogers ; Z. bao ; K. Baldwin ; A. Dodabalapur ; B. Crone ; V. R. Raju ; V. Kuck ; H. Katz ; K. Amundson ; J. Ewing.** *Proc. Natl. Acad. Sci. USA,* 2001, vol. 98, 4835
- **H. E. Katz ; J. Johnson ; A. J. Lovinger ; W. Li.** *J. Am. Chem. Soc,* 2000, vol. 122, 7787
- **Lay-Lay Chua ; Peter K. H. Ho ; Henning Sirringhaus ; R.H. Friend.** *Appl. Phys. Lett.,* 2004, vol. 84, 3400
- **F. Dinelli ; M. Murgia ; P. Levy ; M. Cavallini ; F. Biscarini ; D. M. de Leeuw.** *Phys. Rev.,* 2004, vol. 92, 116802
- **V. D. Mihailetchi ; J. K. J. van Duren ; P. W. M. Blom ; J. C. Hummelen ; R. A. J. Janssen ; J. M. Kroon ; M. T. Rispens ; W. J. H. Verhees ; M. M. Wienk.** *Adv. Func. Mater.,* 2003, vol. 13, 43
- **G. J. Matt ; N. S. Sariciftci ; T. Fromherz.** *Appl. Phys. Lett.,* 2004, vol. 84, 1570
- **S. M. Sze.** Physics of Semiconductor Devices. Wiley, 1981